(19) **Europäisches Patentamt / European Patent Office / Office européen des brevets**

(11) **EP 1 580 893 B1**

(12) **FASCICULE DE BREVET EUROPEEN**

(45) Date de publication et mention de la délivrance du brevet:
**02.05.2007 Bulletin 2007/18**

(51) Int Cl.:
*H03L 7/087* ^(2006.01)    *G01R 25/08* ^(2006.01)

(21) Numéro de dépôt: **05102026.1**

(22) Date de dépôt: **15.03.2005**

(54) **Dispositif et procédé de détection de phase d'un signal**

Vorrichtung und Verfahren zur Phasendetektion eines Signals

Device and method for phase detection of a signal

(84) Etats contractants désignés:
**DE GB IT**

(30) Priorité: **17.03.2004 FR 0450534**

(43) Date de publication de la demande:
**28.09.2005 Bulletin 2005/39**

(73) Titulaire: **COMMISSARIAT A L'ENERGIE ATOMIQUE**
**75015 Paris (FR)**

(72) Inventeurs:
• **Reverdy, Jacques**
  **38920 Crolles (FR)**
• **Crochon, Elisabeth**
  **38320 Poisat (FR)**
• **Robert, Gérard**
  **38320 Poisat (FR)**
• **Thomas, Thierry**
  **38760 Varces Allières et Risset (FR)**

(74) Mandataire: **Poulin, Gérard et al**
**Brevatome**
**3, rue du Docteur Lancereaux**
**75008 Paris (FR)**

(56) Documents cités:
**US-A- 5 723 989        US-A- 6 049 297**
**US-B1- 6 486 716**

## Description

### DOMAINE TECHNIQUE ET ART ANTERIEUR

La présente invention concerne un procédé ainsi qu'un dispositif permettant d'extraire la phase d'un signal éventuellement bruité, ou une référence de phase d'un signal modulé et éventuellement bruité.

Elle trouve notamment une application dans le domaine des systèmes RFID ou systèmes d'identification par radiofréquence. Un système RFID est formé généralement d'un premier dispositif comprenant des données mémorisées, en général appelé étiquette, apte à transmettre ces données sous forme d'ondes radio selon une fréquence appartenant à une gamme comprise généralement entre quelques kHz et quelques MHz. Un second dispositif de lecture est alors prévu pour permettre de faire l'acquisition desdites données mémorisées. Pour réaliser cette acquisition, le second dispositif est susceptible d'émettre un signal S formé à partir d'une porteuse. En réponse à ce signal S, le premier dispositif, émet alors, un autre signal S' comprenant lesdites données. Cet autre signal S' est, selon un protocole préétabli, généralement formé à partir d'une sous-porteuse de fréquence proportionnelle à celle de ladite porteuse. Ledit autre signal S' peut être modulé par exemple selon une modulation de phase.

Pour que le dispositif de lecture puisse démoduler ledit autre signal S', ce dernier doit de préférence pouvoir détecter une référence de phase de cet autre signal S'. Pour cela, un certain nombre de cycles peuvent être spécifiquement insérés au début de l'autre signal S' pour permettre au dispositif de lecture d'avoir le temps de détecter cette référence de phase. Une méthode connue dite « méthode de corrélation » est couramment utilisée pour effectuer ce type de détection. Cette méthode consiste à multiplier un ou plusieurs cycles dudit autre signal S' dont on cherche la référence de phase par un ou plusieurs cycles d'un signal de référence $S_0$, de fréquence identique à celle de ladite sous-porteuse.

Les résultats obtenus de ces multiplications, analogiques ou numériques, sont intégrés sur une ou plusieurs périodes. Ces opérations sont répétées régulièrement dans le temps et donnent un maximum à l'instant où l'autre signal S' et le signal de référence $S_0$ sont en phase. L'instant de ce maximum correspond à un instant pris comme référence de phase pour l'autre signal S'.

Cette méthode présente pour inconvénient de manquer de précision, notamment lorsque l'autre signal S', est entaché de bruit. En outre, elle mobilise d'importantes ressources au niveau du dispositif de lecture.

Le document US 5 723 989 divulgue un dispositif permettant de déterminer un déphasage entre un premier signal S1 et un deuxième signal S2 numériques ou analogiques. Ce dispositif comprend des premiers moyens de détection de front et des seconds moyens de détection de front, prévus pour détecter respectivement un changement d'état du premier signal S1 et un changement d'état du second signal S2. Les premiers moyens de détection sont reliés à un compteur, dont le comptage est dirigé par un signal d'horloge et initialisé par une détection d'un changement d'état du premier signal S1. Un circuit de commande, relié aux premiers moyens de détection de front et aux seconds moyens de détection de front, est quant à lui prévu pour indiquer, les instants où la sortie du compteur est valide. A ces instants, la différence de phase entre le signal S1 et le signal S2, est fonction de la grandeur de sortie du compteur.

### EXPOSÉ DE L'INVENTION

La présente invention propose un procédé d'estimation du déphasage d'un signal selon la revendication 1. Ce procédé d'estimation ou de mesure du déphasage d'un signal $S_1$, de période sensiblement égale à une période Ts par rapport à un signal de référence $S_0$ de période Ts, comporte les étapes consistant à recevoir le signal $S_1$ et lancer un processus de capture comprenant les étapes consistant à :

    a) effectuer, à des instants régulièrement répartis dans un premier intervalle de temps égal à la période Ts, une succession de n détections n étant un entier supérieur à 1, de l'état du signal $S_1$ et pour chacune de ces détections, accroître ou laisser inchangée en fonction dudit état une variable de comptage donnée d'une succession de n variables de comptage,

    b) réitérer l'étape a) sur un ou plusieurs autres intervalles de temps chacun égal audit premier intervalle de temps,

    c) arrêter à un instant de fin de capture $t_{fin}$ le processus de capture,

    d) Comparer dans ladite succession de variables de comptage les valeurs deux à deux respectives des variables de comptage de moyens de comptage adjacents,

    e) identifier les deux variables de comptage adjacentes $x_j$ et $x_{j+1}$ présentant le plus grand écart parmi tous les écarts entre deux variables adjacentes, où j est un entier.

Le déphasage entre le signal de référence $S_0$ et le signal $S_1$ peut être estimé après l'étape e) par une valeur de déphasage entre $(j/n)*2\Pi$ et $((j+1)/n)*2\Pi$, par exemple $(j/n)*2\Pi$.

Le signal $S_1$ traité peut être un signal numérique numérisé sur un ou plusieurs bits. Ce dernier peut être également un signal numérique obtenu par numérisation d'un signal analogique ou obtenu par traitement d'un signal analogique.

Le signal $S_1$ peut être éventuellement un signal analogique. Dans ce cas, une étape de traitement du signal S1, par exemple à l'aide d'un ou plusieurs comparateurs ou à l'aide d'un convertisseur analogique/numérique, peut être prévue avant de lancer le processus de capture.

A l'étape a), l'accroissement d'une variable de comptage peut correspondre à une incrémentation de ladite variable de comptage par une valeur d'incrémentation fixe, ou par une valeur d'incrémentation pouvant varier en fonction dudit état détecté.

Dans le cas par exemple où le signal $S_1$ est numérisé sur plusieurs bits et emploi une logique signée, il peut être prévu que la valeur d'incrémentation soit signée et que le signe de la valeur d'incrémentation varie en fonction de l'état du signal $S_1$ détecté. Il peut être prévu également que ladite valeur d'incrémentation varie en fonction de l'état du signal $S_1$ détecté et de la valeur moyenne ou de l'état moyen du signal $S_1$ à l'instant de détection.

L'accroissement d'une variable de comptage peut correspondre également à une opération autre qu'une incrémentation sur cette variable de comptage. Elle peut consister, par exemple, en une multiplication de cette variable de comptage par une valeur fonction de l'état du signal $S_1$ détecté.

Le processus de capture selon l'invention peut être réitéré pendant un nombre entier de périodes de durée Ts. Selon une variante, le processus de capture effectué à l'étape b) et à l'étape c) peut être réitéré jusqu'à ce qu'une desdites variables de comptage atteigne une valeur Xseuil_1. Cette valeur seuil Xseuil_1 peut être prédéterminée et fixe, ou selon une variante être initialisée à une valeur prédéterminée et varier au cours du processus de capture, par exemple en fonction du rapport signal sur bruit relatif au signal $S_1$ ou/et du débit d'information relatif au signal $S_1$.

Selon une autre variante, le processus de capture peut être réitéré jusqu'à ce que la différence de variable de comptage en sortie de deux moyens de comptage adjacents atteigne un seuil Xseuil_2.

Ce seuil Xseuil_2 peut être prédéterminée et fixe ou, selon une variante, être initialisé à une valeur prédéterminée et varier au cours dudit processus de capture, par exemple en fonction du rapport signal sur bruit relatif au signal $S_1$, ou du débit d'informations amené par le signal $S_1$.

L'invention concerne en outre un procédé de lecture d'un transpondeur ou d'une étiquette comportant :

- l'émission, par un dispositif de lecture, d'un signal d'une fréquence prédéterminée,
- la réception, par le dispositif de lecture, d'un autre signal $S_1$ émis par le transpondeur ou l'étiquette,
- la mise en oeuvre d'un des procédés précédemment décrits.

Le signal $S_0$ peut être généré par le dispositif de lecture, à partir dudit signal de fréquence prédéterminée, par exemple par division de fréquence dudit signal de fréquence prédéterminée ou à l'aide d'un oscillateur local intégré au dispositif de lecture.

L'invention concerne encore un dispositif d'estimation du déphasage d'un signal selon la revendication indépendante 14. Ce dispositif d'estimation du déphasage d'un signal $S_1$ de période sensiblement égale à Ts par rapport à un signal de référence $S_0$ de période Ts, comprend :

- n moyens de comptage, en étant supérieur à 1, chacun des moyens de comptage étant apte, lorsqu'il est actionné, à détecter un état instantané du signal $S_1$ et à accroître ou laisser inchangée une variable de comptage à laquelle il est associé parmi n variables de comptage en fonction dudit état instantané détecté,
- des moyens de commande aptes à actionner, de manière périodique, successivement et dans un ordre préétabli, lesdits n moyens de comptage, dans un intervalle de temps de durée égale à la période Ts du signal $S_0$ et à des instants régulièrement répartis dans ledit intervalle de temps,
- des moyens comparateurs aptes à comparer parmi les n variables de comptage des n moyens de comptage, deux à deux les valeurs de variables de comptage de chacun des moyens de comptages adjacents, la comparaison effectuée par lesdits moyens comparateurs permettant de déterminer l'écart le plus grand.

Le dispositif d'estimation de déphasage suivant l'invention peut également comprendre en outre :

- des moyens d'estimation du déphasage entre $S_0$ et $S_1$ en fonction dudit écart le plus grand déterminé.

Selon un mode de réalisation particulier du dispositif chacun des moyens de comptage peut être apte, lorsqu'il est actionné, à détecter un état instantané du signal $S_1$ et à incrémenter ou laisser inchangée une variable de comptage à laquelle il est associé parmi N variables de comptage en fonction dudit état instantané détecté.

Le dispositif peut en outre comporter : des moyens de détermination de la valeur moyenne ou de l'état moyen M du signal $S_1$. Chacun des moyens de comptage peut alors être prévu pour, lorsqu'il est actionné, détecter un état instantané du signal $S_1$ et incrémenter ou laisser inchangée une variable de comptage à laquelle il est associé parmi N variables de comptage, en fonction dudit état instantané détecté et de ladite valeur moyenne M du signal $S_1$.

Des moyens pour générer le signal $S_0$ de période $T_S$ peuvent être également intégrés au dispositif suivant l'invention. Ces moyens peuvent comprendre un oscillateur tel qu'une horloge ou/et des moyens diviseurs de fréquence.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

- la figure 1 illustre un exemple dispositif mis en oeuvre suivant l'invention,
- la figure 2 illustre un chronogramme de fonctionnement d'un dispositif mis en oeuvre suivant l'invention,
- la figure 3 illustre une variante de dispositif mis en oeuvre suivant l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

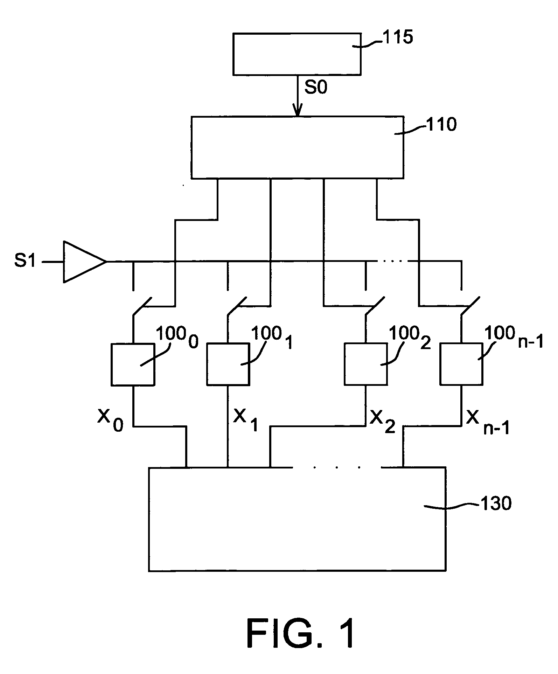

Un exemple de dispositif mis en oeuvre suivant l'invention va à présent être décrit en liaison avec la figure 1. Ce dispositif permet notamment la détermination temporelle d'un instant de référence de phase, ou de détecter la phase d'un signal $S_1$, par rapport à un signal de référence $S_0$ de période Ts, ou encore de détecter le déphasage de $S_1$ par rapport à $S_0$.

Le signal $S_1$ peut être par exemple un signal numérique, éventuellement bruité, de période identique à, ou voisine de, celle, Ts, du signal de référence $S_0$.

Le signal $S_1$ peut être encore par exemple un signal numérique à deux états modulé, par exemple modulé en phase à partir d'une porteuse de période égale à celle Ts du signal $S_0$ de référence.

Le dispositif mis en oeuvre suivant l'invention comprend tout d'abord des moyens de commande 110 recevant le signal de référence $S_0$ en entrée et permettant, de manière périodique, d'actionner successivement, dans un intervalle de temps de durée égale à la période Ts du signal $S_0$ et à des instants régulièrement répartis dans ledit intervalle de temps, n différents moyens de comptage $100_0$,...,$100_{n-1}$.

Selon un mode de réalisation particulier, des moyens, notés 115, par exemple sous forme d'une horloge telle qu'une horloge à base de piézoélectrique, peuvent être intégrés audit dispositif pour générer et émettre le signal de référence $S_0$ de période Ts, notamment en entrée des moyens de commande 110.

Après que le signal $S_1$ a été reçu en entrée dudit dispositif et à partir du moment où ce dernier commence à effectuer un processus de mesure de déphasage du signal $S_1$, un moyen de comptage donné $100_i$ parmi les n moyens de comptage ($100_0$,...,$100_{n-1}$) peut être actionné par exemple par les moyens de commande 110 à des instants $t_i = t_0 + i*(Ts/n) + k*Ts$ (1).

Dans l'expression référencée (1), '$t_0$' est un instant où un processus de détection de phase du signal $S_1$ débute. 'i' correspond au rang du moyen de comptage donné $100_i$, ce dernier étant le i-ème moyen de comptage effectuant une détection dans un intervalle de temps égal à Ts, après qu'un premier moyen de comptage $100_0$ a effectué le premier une détection dans ledit intervalle de temps. 'n' correspond au nombre total de moyens de comptage $100_0$,..., $100_{n-1}$, et 'k' est un entier correspondant au nombre de détections effectuées au total par le moyen de comptage donné $100_i$.

Le nombre n de moyens de comptage peut varier par exemple en fonction de la précision de la détection recherchée. Selon un mode de réalisation particulier, le nombre n de moyens de comptage peut être égal à une puissance de 2.

Chacun des différents moyens de comptage $100_0$,...,$100_{n-1}$ est associé à une variable de comptage qu'il est susceptible de modifier et dont il produit la valeur en sortie. Les différents moyens de comptage $100_0$,..., $100_{n-1}$ produisent respectivement en sortie les variables de comptage $x_0$,..., $x_{n-1}$. Ils ont entre eux des modes de fonctionnement identiques.

Lorsqu'un moyen de comptage donné $100_i$ (i ∈ [0;n-1]) est actionné par les moyens de commande 110 à un instant donné $t_i$ (i ∈ [0;n-1]), ce moyen de comptage donné $100_i$ détecte l'état ou la valeur du signal $S_1$. Ledit moyen de comptage donné $100_i$ est alors susceptible, en fonction de l'état détecté du signal $S_1$, de modifier ou non une variable de comptage donnée $x_i$ (i ∈ [0;n-1]) à laquelle il est associé et dont il produit la valeur en sortie.

La modification éventuelle de la variable de comptage donnée $x_i$, consiste en un accroissement, par exemple une incrémentation de cette dernière, d'une valeur d'incrémentation $Q_1$.

Dans la mesure où le signal $S_1$ est un signal à deux états, selon une première variante, il peut être prévu, par exemple qu'un moyen de comptage donné $100_i$, incrémente la variable de comptage donnée $x_i$ à laquelle ce dernier est associé, de la valeur d'incrémentation $Q_1$, lorsqu'il détecte un état « haut » ou un niveau logique égal à '1' du signal $S_1$. Selon cette même première variante, le moyen de comptage donné $100_i$ laisse inchangée la variable de comptage donnée $x_i$ à laquelle ce dernier est associé lorsqu'il détecte un état « bas » ou un niveau logique égal à '0' du signal $S_1$.

Selon une seconde variante il peut être prévu par exemple, que le moyen de comptage donné $100_i$, incrémente la variable de comptage donnée $x_i$ à laquelle ce dernier est associé, de la valeur d'incrémentation $Q_1$, lorsqu'il détecte un état « bas » ou un niveau logique égal à '0' du signal $S_1$. Selon cette même seconde variante, ledit moyen de comptage donné $100_i$ laisse inchangée la variable de comptage donnée xi à laquelle ce dernier est associé lorsqu'il détecte un état « haut » ou un niveau logique égal à '1' du signal $S_1$.

Dans la mesure où le signal $S_1$ est un signal à deux états, les moyens de comptage $100_0$, ..., $100_{n-1}$,

peuvent être réalisés par exemple à partir de compteurs formés selon un agencement donné de portes logiques.

Des moyens comparateurs notés 130 qui peuvent être reliés à toutes les sorties des différents moyens de comptage $100_0,...,100_{n-1}$ permettent de comparer deux à deux les valeurs des variables de comptage de chaque couple moyens de comptages « adjacents » ou « voisins ».

Un moyen de comptage donné $100_i$ sera dit « voisin » ou « adjacent » d'un autre moyen de comptage $100_j$ lorsque ledit moyen de comptage donné est, parmi tous les moyens de comptage $100_0,...,100_{n-1}$, le moyen de comptage ayant réalisé une détection juste avant ou juste après ledit autre moyen de comptage $100_j$.

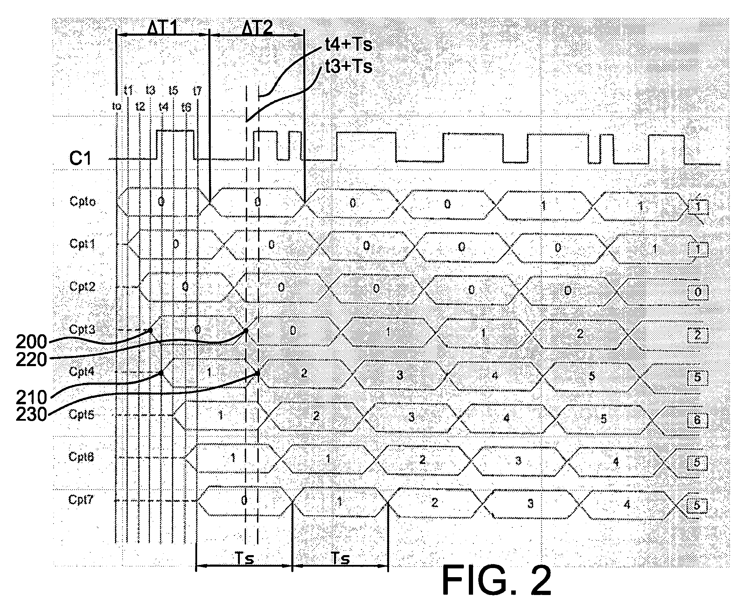

Un exemple de procédé de détection de phase suivant l'invention, effectué par un dispositif du type de celui précédemment décrit, mais doté cette fois de n=8 moyens de comptage $100_0,...,100_7$ va à présent être explicité en liaison avec la figure 2.

Il s'agit de détecter la phase du signal $S_1$ (courbe en créneau notée $C_1$) à l'aide du signal de référence $S_0$ (non représenté mais dont la période est égale à Ts).

Le fonctionnement au cours du temps des différents moyens de comptage $100_0,..., 100_7$ est représenté sur la figure 2, respectivement par les chronogrammes notés $Cpt_0$, $Cpt_1$, $Cpt_2$, $Cpt_3$, $Cpt_4$, $Cpt_5$, $Cpt_6$, $Cpt_7$.

A un instant de départ noté $t_0$ après que le signal $S_1$ a été reçu à l'entrée dudit dispositif mis en oeuvre suivant l'invention, un processus de capture du déphasage de $S_1$ par rapport à $S_0$ débute.

Alors, à partir de cet instant de départ $t_0$, dans un premier intervalle de temps $\Delta T_1$ de préférence égal à la période Ts du signal de référence $S_0$, lesdits moyens de commande 110 actionnent successivement à des instants notés $t_0$, $t_1$, $t_2$, $t_3$, $t_4$, $t_5$, $t_6$, $t_7$, régulièrement répartis au cours dudit premier intervalle de temps $\Delta T_1$, une seule fois chacun les différents moyens de comptage $100_0,...,100_7$, du premier moyen comptage $100_0$ au huitième moyen de comptage $100_7$.

Au cours dudit premier intervalle de temps $\Delta T_1$, les moyens de comptage $100_0,...,100_7$, effectuent ainsi chacun une seule détection du signal $S_1$ et modifient ou non en fonction de cette détection, les valeurs de leurs variables de comptage respectives.

Les moyens de comptage $100_0,...,100_7$, permettent ainsi d'enregistrer des images successives de l'état du signal $S_1$. Certains des moyens de comptage $100_0,...,100_7$ auront détecté un certain état du signal $S_1$ durant le premier intervalle de temps $\Delta T_1$. Certains autres des moyens de comptage $100_0,...,100_7$ auront détecté un autre état du signal $S_1$.

Par exemple, à un instant noté $t_3$ (référencé 200 sur le chronogramme $Cpt_3$) dans l'intervalle de temps $\Delta T_1$, le moyen de comptage $100_3$ correspondant au chronogramme $Cpt_3$ a détecté un état « bas » du signal $S_1$, la valeur de la variable $x_3$ de comptage à laquelle ce dernier est associé reste alors inchangée et égale à la valeur 0. A un autre instant noté $t_4$ (référencé 210 sur le

chronogramme $Cpt_4$) dans l'intervalle de temps $\Delta T_1$, le moyen de comptage $100_4$ associé au chronogramme $Cpt_4$ a détecté un état « haut » du signal $S_1$, la valeur de la variable $x_4$ de comptage à laquelle ce dernier est associé, est alors incrémentée et mise à la valeur 1.

Le premier intervalle de temps $\Delta T_1$ étant égal à la période Ts du signal $S_0$, la référence de phase ou l'origine de phase du signal $S_1$ est encadrée de manière temporelle entre deux instants $t_j$ et $t_{j+1}$ (avec $j \in [0;6]$) de détection du signal $S_1$ respectivement de deux moyens de comptage adjacents $100_j$ et $100_{j+1}$. A la fin de l'intervalle de temps $\Delta T_1$, lesdits deux moyens de comptage adjacents $100_j$ et $100_{j+1}$ auront des variables de comptage respectives $x_j$ et $x_{j+1}$ de valeurs différentes, l'un desdits deux moyens de comptage adjacents ayant détecté un certain état logique du signal par exemple un état « bas », l'autre ayant détecté un autre état logique du signal, par exemple un état « haut ».

Le signal $S_1$, pouvant être bruité ou un signal modulé éventuellement bruité, une fois le premier intervalle de temps écoulé $\Delta T_1$, l'opération décrite plus haut est de préférence réitérée.

Alors, dans un second intervalle de temps $\Delta T_2$ égal à Ts, les moyens de commande 110 actionnent à nouveau à des instants régulièrement répartis dans ce second intervalle de temps $\Delta T_2$ et dans le même ordre que précédemment, chacun successivement des différents moyens de comptage $100_0,...,100_7$, du premier moyen comptage $100_0$ au un 8-ième moyen de comptage $100_7$.

Dans ce second intervalle de temps $\Delta T_2$, les instants de détection desdits deux moyens de comptage adjacents $100_j$ et $100_{j+1}$ surviennent respectivement à des instants $t_j$ + Ts et $t_{j+1}$ + Ts et encadrent alors à nouveau temporellement la référence de phase du signal $S_1$.

Par exemple, à un instant noté $t_3$ + Ts (référencé 220 sur le chronogramme $Cpt_3$) dans l'intervalle de temps $\Delta T_2$, le moyen de comptage $100_3$ correspondant au chronogramme $Cpt_3$ a détecté un état « bas » du signal $S_1$, la valeur de la variable $x_3$ de comptage à laquelle ce dernier est associé reste alors inchangée et est égale à la valeur 0. A un autre instant noté $t_4$ + Ts (référencé 230 sur le chronogramme $Cpt_4$) dans l'intervalle de temps $\Delta T_2$, le moyen de comptage $100_4$ correspondant au chronogramme $Cpt_4$ a détecté un état « haut » du signal $S_1$, la valeur de la variable $x_4$ de comptage à laquelle ce dernier est associé est alors incrémentée et mise à la valeur 2.

L'opération effectuée durant le premier intervalle de temps $\Delta T_1$ puis durant le second intervalle de temps $\Delta T_2$ peut ainsi être réitérée de manière identique sur plusieurs intervalles de temps égaux à la période Ts, jusqu'à un instant $t_{fin}$ que l'on nommera instant de fin de capture, où les moyens de commande 110 décrits plus haut arrêtent d'actionner les moyens de comptage $100_0,...,100_7$, et où ces derniers s'arrêtent de modifier leurs variables de comptage respectives. Le processus de détection peut avoir une durée totale de détection $\Delta T$ par exemple

telle que :

$$\Delta T = m*Ts$$

(où 'm' est un nombre entier, de préférence supérieur à 1).

Plusieurs variantes de mises en oeuvre peuvent être prévues pour déclencher la fin du processus de capture précédemment décrit.

Selon une première variante, il peut être prévu que le processus de capture s'achève par exemple au bout d'une durée prédéterminée fixe après l'instant de début $t_0$ ou d'une durée qui pourra varier, par exemple en fonction de plusieurs facteurs tels que le débit d'information apporté par le signal $S_1$, le rapport signal à bruit relatif au signal $S_1$.

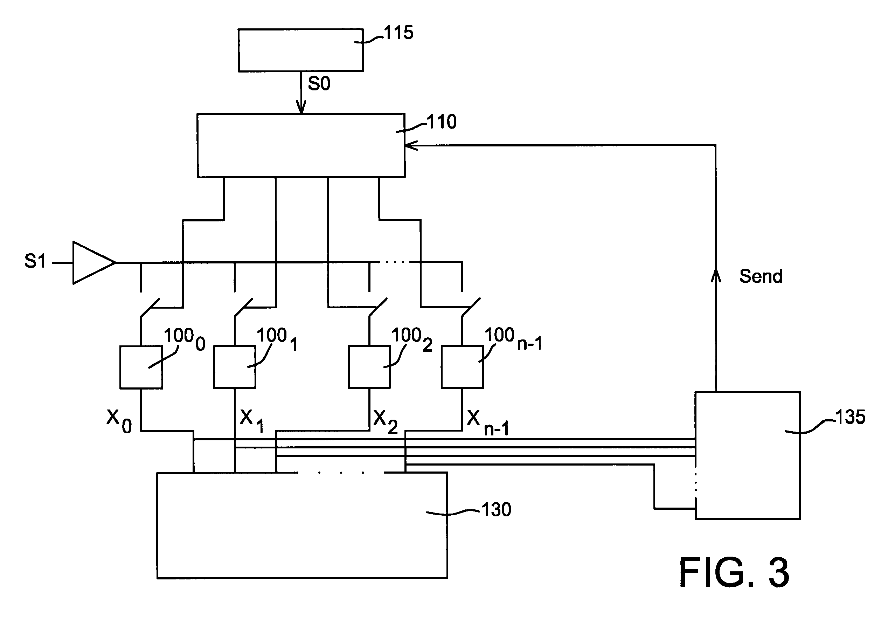

Selon une seconde variante illustrée sur la figure 3, des moyens notés 135 spécifiques peuvent être prévus pour permettre de déclencher la fin du processus de capture.

Ces moyens 135, par exemple formés d'un agencement de portes logiques, peuvent permettrent par exemple de comparer avec un seuil Xseuil_1, la valeur respectivement de chacune des variables de comptage en sortie des différents moyens de comptage $100_0$, ..., $100_7$. Lorsqu'une variable de comptage donnée $x_i$, en sortie d'un moyen de comptage donné $100_i$, atteint la valeur du seuil Xseuil_1, les moyens 130 de détection de fin de capture émettent en sortie un signal de fin de capture $S_{fin}$, par exemple vers les moyens de commande 110 pour que ces derniers cessent d'actionner les moyens de comptage $100_0$,..., $100_7$, et éventuellement vers les moyens comparateurs 120, à la fin d'un cycle complet.

Le seuil Xseuil_1 peut être une valeur prédéterminée fixe. Le seuil Xseuil_1 peut être également une variable initialisée à une valeur prédéterminée et qui est modifiée au cours du processus de comptage en fonction d'un ou plusieurs facteurs tels que par exemple le débit d'information apporté par le signal $S_1$, le rapport signal à bruit relatif au signal $S_1$. On entend par débit le nombre de bits par seconde (bits qui modulent la phase, c'est-à-dire qui donnent les informations).

L'instant de fin de capture $t_{fin}$ survenu, les moyens de commande 110 cessent d'actionner les moyens de comptage $100_0$,..., $100_7$. Des moyens comparateurs 130 tels que ceux décrits plus haut, permettent alors de comparer en sortie de tous les moyens de comptage $100_0$,..., $100_7$ deux à deux les variables de comptage de chaque couple de moyens de comptages « adjacents » ou « voisins » et identifient le couple de moyens de comptage adjacents présentant en sortie la différence de variable de comptage la plus importante.

Les instants $t_j + k_1*Ts$ et $t_{j+1} + k_1*Ts$ (avec j et $k_1$ des nombres entiers) auxquels chacun respectivement des moyens de comptage dudit couple de moyen de comptage ont effectué leurs détection encadrent temporellement l'instant de référence de phase. D'après l'expression référencée (1) précédemment décrite, les instants $t_j + k_1*Ts$ et $t_{j+1} + k_1*Ts$ coïncident respectivement avec les instants $t_0 + j*(Ts/n) + k*Ts$ et $t_0 + (j+1)*(Ts/n) + k*Ts$.

Le déphasage entre le signal $S_0$ et le signal $S_1$ peut alors être estimé à une valeur comprise entre $(j*2\Pi)/n$ et $((j+1)*2\Pi)/n)$, par exemple $(j*2\Pi)/n$.

Dans l'exemple de la figure 2, il s'agit du moyen de comptage $100_3$, dont le fonctionnement est illustré par le chronogramme Cpt3 et du moyen de comptage $100_4$ dont le fonctionnement est illustré par le chronogramme Cpt4. Le moyen de comptage $100_3$ et le moyen de comptage $100_4$ effectuent leurs détections respectivement à des instants $t_3 + k_1*Ts$ et $t_4 + k_1*Ts$ encadrant l'instant de référence de phase.

Selon une troisième variante, le processus de capture décrit plus haut peut s'achever lorsque parmi tous les moyens de comptage $100_0$,..., $100_7$ la différence de variable de comptage en sortie de deux moyens de comptage adjacents atteint un certain seuil Xseuil_2 prédéterminé.

Dans cette troisième variante, la fin de capture peut être déclenchée par exemple par les moyens comparateurs 130, ou par d'autres moyens prévus à cet effet. Le seuil Xseuil_2 peut être une valeur prédéterminée fixe. Le seuil Xseuil_2 peut être également associé une variable initialisée à une valeur prédéterminée et qui est modifiée au cours du processus de comptage en fonction par exemple d'un ou plusieurs facteurs tels que le débit d'information apporté par le signal $S_1$, le rapport signal à bruit relatif au signal $S_1$.

L'invention n'est pas limitée à la détection de phase d'un signal numérique et peut s'appliquer à un signal analogique. Des moyens, par exemple sous forme d'un comparateur ou d'un convertisseur analogique/numérique peuvent être alors intégrés au dispositif mis en oeuvre suivant l'invention pour permettre de modifier ledit signal analogique et d'effectuer un traitement sur un signal à deux ou plusieurs états comme cela est décrit précédemment.

L'invention peut également s'appliquer à la détection de phase d'un signal comportant plus de deux états logiques. Elle peut être mise en oeuvre pour détecter la phase d'un signal $S_1$ numérisé sur plusieurs bits.

Le principe de détection peut être alors semblable à celui précédemment décrit.

Lorsqu'un moyen de comptage donné $100_i$ ($i \in [0;n-1]$) est actionné par les moyens de commande 110 à un instant donné $t_i$, ce moyen de comptage donné $100_i$ détecte un état ou une valeur logique du signal $S_1$. Ledit moyen de comptage donné $100_i$ est alors susceptible, en fonction de l'état détecté du signal $S_1$, de modifier ou non une variable de comptage donnée $x_i$ à laquelle il est associé et dont il produit la valeur en sortie.

La modification éventuelle de la variable de comptage donnée $x_i$, consiste en une incrémentation de cette dernière, d'une valeur d'incrémentation $Q_2$, susceptible de varier en fonction de l'état du signal $S_2$ détecté. Par état du signal $S_2$, on entend l'état de chacun des bits formant le signal $S_2$.

Cette variante peut être réalisée par exemple à l'aide d'un dispositif comprenant un nombre d'entrées égales au nombre de bits du signal $S_1$. Chacun des moyens de comptage est alors susceptible de détecter l'état de chaque bit du signal $S_1$.

Il peut être prévu, par exemple que les moyens de comptage fonctionnent selon une logique signée :

Prenons par exemple un cas où le signal $S_2$ est un signal numérisé sur 3 bits notés $a_2a_1a_0$ où $a_2$ est un bit de poids fort. Il peut être prévu selon une première variante qu'un moyen de comptage donné $100_i$ incrémente alors la variable de comptage donnée $x_i$ à laquelle ce dernier est associé, d'une valeur égale à - ($a_1*2^1 + a_0*2^0$), lorsqu'il détecte un état ou un niveau logique égal à '$0a_1a_0$' et d'une valeur égale à + ($a_1*2^1 + a_0*2^0$) lorsqu'il détecte un état ou un niveau logique égal à '$1a_1a_0$' du signal $S_2$. Le signe de la valeur d'incrémentation $Q_2$ peut être ainsi en fonction de l'état du signal $S_1$.

Dans les exemples précédemment décrits, les moyens de comptage du dispositif suivant l'invention sont mis en oeuvre pour qu'à chaque fois qu'un moyen de comptage donné effectue une détection d'un signal, ledit moyen de comptage incrémente ou laisse inchangée une variable de comptage à laquelle ce dernier est associé d'une valeur d'incrémentation qui peut être fixe ou variable en fonction de l'état dudit signal.

La présente invention n'est pas limitée à ces exemples de fonctionnement. Les moyens de comptage peuvent être prévus pour effectuer à chaque détection des opérations ou des fonctions plus complexes qu'une simple incrémentation ou sommation. Cela peut permettre d'amplifier plus rapidement l'écart entre les différentes variables de comptages et de réduire la durée du procédé de détection.

De manière plus générale, les moyens de comptages du dispositif suivant l'invention peuvent être prévus par exemple pour qu'à chaque fois qu'un moyen de comptage donné effectue une détection d'un signal, celui-ci accroisse ou laisse inchangé une variable de comptage à laquelle il est associé. L'accroissement peut être réalisé par exemple par une multiplication de la variable par un nombre proportionnel ou égal à la valeur de l'état dudit signal lors de la détection, ou par une autre fonction mathématique éventuellement fonction de l'état du signal lors de la détection.

L'invention peut trouver une application notamment dans le domaine des systèmes RFID ou systèmes d'identification radiofréquence. Un dispositif de détection de phase mis en oeuvre suivant l'invention peut être intégré par exemple à un dispositif de lecture RFID, permettant de faire l'acquisition, par échange de signaux radiofréquences, de données comprises dans un autre dispositif se présentant par exemple sous forme d'une étiquette ou d'un transpondeur.

L'acquisition de données comprises dans une étiquette ou un transpondeur par un dispositif de lecture RFID mis en oeuvre suivant l'invention, peut alors être effectuée de la manière suivante :

Le dispositif de lecture suivant l'invention est susceptible d'émettre un signal S, à partir d'une porteuse d'une certaine fréquence.

En réponse à cette porteuse, le transpondeur ou l'étiquette émet un autre signal $S_1$ modulé en phase. Cet autre signal $S_1$ est généralement formé, selon un protocole préétabli, à partir d'une sous-porteuse de fréquence sous-multiple de la fréquence de ladite porteuse émise par le dispositif de lecture.

L'autre signal $S_1$ peut être éventuellement entaché de bruit (saut de phase, impulsions parasites).

Pour que le dispositif de lecture puisse lire les variations de l'autre signal $S_1$ émis par l'étiquette ou le transpondeur, ledit dispositif de lecture suivant l'invention est alors susceptible, de créer un signal $S_0$, de période Ts égale à la période de ladite sous-porteuse à partir de laquelle est formée le signal $S_1$ émis par l'étiquette ou le transpondeur. Le signal $S_0$ peut être formé par exemple à partir d'une ou plusieurs horloges à base de piézoélectrique comme cela été décrit précédemment ou par division de fréquence de la porteuse, à l'aide de moyens diviseurs de fréquence. La fréquence de la sous-porteuse à partir de laquelle l'autre signal $S_1$ est formé, est ainsi connue du dispositif de lecture. L'origine de phase ou la référence de phase de l'autre signal $S_1$ reste à déterminer, pour que ce dernier puisse être démodulé.

Pour déterminer cette origine de phase, une estimation du déphasage entre le signal de référence $S_0$ et le signal $S_1$ peut alors être effectuée au moyen d'un procédé tel que précédemment décrit. Cette estimation de déphasage pourra permettre de générer un signal $S'_0$ de période égale à la période Ts de la sous porteuse et synchronisé avec $S_1$ afin de déterminer les modulations de phase de $S_1$ porteur d'information.

Ce procédé peut éventuellement débuter dès que le dispositif de lecture reçoit le signal $S_1$.

## Revendications

1. Procédé d'estimation du déphasage d'un signal $S_1$ de période sensiblement égale à la période Ts par rapport à un signal de référence $S_0$ de période Ts, comportant après réception du signal $S_1$ le lancement d'un processus de capture comprenant les étapes suivantes :

   a) effectuer, à des instants régulièrement répartis dans un premier intervalle de temps égal à la période Ts, une succession de n détections n étant un entier supérieur à 1, de l'état du signal $S_1$ et pour chacune de ces détections, accroître ou laisser inchangée en fonction dudit état une variable de comptage donnée d'une succession de n variables de comptage $x_0$, ..., $x_{n-1}$,

b) réitérer l'étape a) sur un ou plusieurs autres intervalles de temps chacun égal audit premier intervalle de temps,

c) arrêter à un instant de fin de capture $t_{fin}$ ledit processus de capture, ledit procédé comprenant en outre les étapes consistant à :

d) comparer dans ladite succession de variables de comptage $x_0$,..., $x_{n-1}$ les valeurs deux à deux respectives des variables de comptage de moyens de comptage adjacents,

e) identifier les deux variables de comptage adjacentes $x_j$ et $x_{j+1}$ présentant le plus grand écart parmi tous les écarts entre deux variables adjacentes, où j est un entier,

f) calculer le déphasage entre $S_0$ et $S_1$.

2. Procédé selon la revendication 1, l'action d'accroître ladite variable de comptage à l'étape b) correspondant à une incrémentation de ladite variable de comptage d'une valeur d'incrémentation fixe, ou apte à varier en fonction dudit état détecté.

3. Procédé selon la revendication 1 ou 2, l'étape b) étant réitérée pendant un nombre entier de périodes de durée Ts.

4. Procédé selon l'une des revendications 1 à 3, le processus de capture étant réitéré jusqu'à ce qu'une des variables de comptage atteigne une valeur Xseuil_1, Xseuil_1 étant prédéterminée ou/et susceptible de varier au cours dudit processus de capture.

5. Procédé selon l'une des revendications 1 à 4, le processus de capture étant réitéré jusqu'à ce que la différence de variable de comptage en sortie de deux moyens de comptage adjacents atteigne un seuil Xseuil_2, Xseuil_2 étant prédéterminé ou/et susceptible de varier au cours dudit processus de capture.

6. Procédé selon l'une des revendications 1 à 5, le signal $S_1$ étant un signal numérique.

7. Procédé selon la revendication 6, le signal numérique étant obtenu par numérisation d'un signal analogique.

8. Procédé selon l'une des revendications 1 à 5, le signal $S_1$ étant un signal analogique.

9. Procédé selon l'une des revendications 1 à 5, le signal $S_1$ étant un signal numérisé sur plusieurs bits.

10. Procédé selon la revendication 9, les moyens de comptage incrémentant la variable de comptage d'une valeur d'incrémentation $Q_2$ dont le signe est fonction de l'état du signal numérisé détecté.

11. Procédé selon l'une des revendications 1 à 10, le déphasage étant estimé par une valeur choisie dans un intervalle compris entre $(j/n)*2\Pi$ et $((j+1)/n)*2\Pi$.

12. Procédé de lecture d'un transpondeur ou d'une étiquette comportant :

    - l'émission, par un dispositif de lecture, d'un signal d'une fréquence prédéterminée,
    - la réception, par le dispositif de lecture, d'un autre signal $S_1$ émis par le transpondeur ou l'étiquette,
    - la mise en oeuvre d'un procédé selon l'une des revendications 1 à 12.

13. Procédé selon la revendication 12, un signal $S_0$ de période Ts étant généré par le dispositif de lecture.

14. Dispositif d'estimation du déphasage d'un signal $S_1$ de période sensiblement égale à la période Ts par rapport à un signal de référence $S_0$ de période Ts comprenant :

    - n moyens de comptage ($100_0$,..., $100_{n-1}$), n étant un entier supérieur à 1, chacun des moyens de comptage étant apte, lorsqu'il est actionné, à détecter un état instantané du signal $S_1$ et à accroître ou laisser inchangée une variable de comptage à laquelle il est associé parmi n variables de comptage $x_0$,..., $x_{n-1}$ en fonction dudit état instantané détecté,
    - des moyens de commande (110) aptes à actionner, de manière périodique, successivement et dans un ordre préétabli, lesdits n moyens de comptage, dans un intervalle de temps de durée égale à la période Ts du signal $S_0$ et à des instants régulièrement répartis dans ledit intervalle de temps,
    - des moyens comparateurs (130) aptes à comparer parmi les n variables de comptage $x_0$, ..., $x_{n-1}$ des n moyens de comptage ($100_0$,..., $100_{n-1}$), deux à deux les valeurs de variables de comptage de chacun des moyens de comptages adjacents, la comparaison effectuée par lesdits moyens comparateurs permettant de déterminer l'écart le plus grand
    - des moyens d'estimation du déphasage entre $S_0$ et $S_1$ en fonction dudit écart le plus grand déterminé.

15. Dispositif selon la revendication 14, chacun des moyens de comptage étant apte, lorsqu'il est actionné, à détecter un état instantané du signal $S_1$ et à incrémenter ou laisser inchangée une variable de comptage à laquelle il est associé parmi n variables de comptage $x_0$, ..., $x_{n-1}$ en fonction dudit état instantané détecté.

**16.** Dispositif selon la revendication 15, comprenant en outre : des moyens de détermination de la valeur moyenne du signal $S_1$, chacun des moyens de comptage étant apte, lorsqu'il est actionné, à détecter un état instantané du signal $S_1$ et à incrémenter ou laisser inchangée une variable de comptage à laquelle il est associé parmi n variables de comptage $x_0,..., x_{n-1}$ en fonction dudit état instantané détecté et de ladite valeur moyenne du signal $S_1$.

**17.** Dispositif selon l'une des revendications 14 à 16, comportant en outre des moyens pour générer un signal $S_0$ de période $T_S$.

**18.** Dispositif selon la revendication 17, comportant les moyens pour générer un signal $S_0$ de période $T_S$, comprenant une horloge ou/et des moyens diviseurs de fréquence.

**19.** Dispositif RFID de lecture d'un transpondeur ou d'une étiquette comportant :

- des moyens d'émission de signaux destinés à une étiquette ou un transpondeur,
- des moyens aptes à recevoir des signaux $S_1$ provenant d'une étiquette ou d'un transpondeur
- un dispositif selon l'une des revendications 14 à 18.

**Claims**

**1.** Method for estimating the phase shift of a signal $S_1$ with a period approximately equal to period Ts with respect to a reference signal $S_0$ with period Ts, comprising steps consisting of receiving the signal $S_1$, and starting a capture process including steps consisting of:

a) at instants regularly distributed within a first time interval equal to the period Ts, carry out a sequence of n detections of the state of the signal $S_1$, where n is an integer greater than 1, and for each of these detections, increasing a given count variable in a sequence of n count variables $x_0, ..., x_{n-1}$, or leaving it unchanged depending on said state,
b) reiterate step a) over one or several other time intervals, each equal to said first time interval,
c) stop the capture process at an end of capture instant $t_{end}$, said method also comprising the steps consisting of:
d) compare the corresponding values of count variables for adjacent count means, in pairs in the said sequence of count variables $x_0, ..., x_{n-1}$,
e) identify the two adjacent count variables $x_j$ and $x_{j+1}$ with the greatest difference, among the differences between two adjacent variables, where j is an integer,
f) calculate the phase shift between $S_0$ and $S_1$.

**2.** Method according to claim 1, the action to increment said count variable in step b) corresponding to an increment in said count variable by a fixed increment value, or by an increment value that can vary as a function of said detected state.

**3.** Method according to claim 1 or 2, step b) being reiterated for an integer number of periods with duration Ts.

**4.** Method according to one of the claims 1 to 3, the capture process being reiterated until one of the count variables reaches a value Xthreshold_1, Xthreshold_1 being predetermined and/or may vary during said capture process.

**5.** Method according to one of the claims 1 to 4, the capture process being reiterated until the difference in the count variable at the output from two adjacent count means reaches a threshold Xthreshold_2, Xthreshold_2 being predetermined and/or may vary during the said capture process.

**6.** Method according to one of the claims 1 to 5, the signal $S_1$ being a digital signal.

**7.** Method according to claim 6, the digital signal being obtained by digitizing an analog signal.

**8.** Method according to claim 5, the signal $S_1$ being an analog signal.

**9.** Method according to one of the claims 1 to 5, the signal $S_1$ being a signal digitized on several bits.

**10.** Method according to claim 9, the count means incrementing the count variable by an increment value $Q_2$ that can vary as a function of the state of the detected digitized signal.

**11.** Method according to one of the claims 1 to 10, the phase shift being estimated by a value chosen within an interval between $(j/n)*2\Pi$ and $((j+1)/n*2\Pi$.

**12.** Method of reading a transponder or a label comprising:

- emission of a signal with a predetermined frequency, by a read device,
- reception of another signal $S_1$ emitted by the transponder or the label, by the read device,
- implementation of a method according to one of the claims 1 to 11.

**13.** Method according to claim 12, a signal $S_0$ with period

Ts being generated by the read device.

**14.** Device for estimating the phase shift of a signal $S_1$ with a period approximately equal to Ts with respect to a reference signal $S_0$ with period Ts, comprising:

- n count means ($100_0$, ..., $100_{n-1}$), n being an integer greater than 1, each of the count means when activated being capable of detecting an instantaneous state of signal $S_1$ and increasing a count variable with which it is associated among n count variations $x_0$, ..., $x_{n-1}$ or leaving it unchanged, as a function of said detected instantaneous state,
- control means (110) capable of periodically and successively activating the said n count means in a predetermined order, within a time interval with a duration equal to the period Ts of the signal $S_0$ and at regularly distributed times in said time interval,
- comparator means (130) capable of comparing the values of count variables $x_0$, ..., $x_{n-1}$ in each adjacent count means ($100_0$, ..., $100_{n-1}$) among the n count variables of the n count means, in pairs, and when the comparison is made, said comparator means determine the greatest difference,
- means capable of estimating the phase shift between $S_0$ and $S_1$ as a function of the said greatest determined difference.

**15.** Device according to claim 14, each of the count means, when activated, being capable of detecting an instantaneous state of the signal $S_1$ and incrementing a count variable with which it is associated among the n count variables $x_0$, ..., $x_{n-1}$ or leaving it unchanged, as a function of said instantaneous detected state.

**16.** Device according to claim 15, also including: means for determining the average value of the signal $S_1$, each of the count means, when activated, being capable of detecting an instantaneous state of the signal $S_1$ and incrementing a count variable with which it is associated among the n count variables $x_0$, ..., $x_{n-1}$ or leaving it unchanged, as a function of said instantaneous detected state and said average value of the signal $S_1$.

**17.** Device according to one of the claims 14 to 16, also including means capable of generating a signal $S_0$ with period Ts.

**18.** Device according to claim 17, including means capable of generating a signal $S_0$ with period Ts, comprising a clock and/or frequency division means.

**19.** RFID read device for a transponder or a label comprising:

- means capable of emitting signals to be sent to a label or a transponder,
- means capable of receiving signals $S_1$ originating from a label or a transponder,
- a device according to one of the claims 14 to 18.

## Patentansprüche

**1.** Verfahren zur Bewertung der Phasenverschiebung eines Signals $S_1$ mit einer Periode im Wesentlichen gleich der Periode Ts in Bezug auf ein Referenzsignal $S_0$ der Periode Ts, bei dem man nach dem Empfang des Signals $S_1$ einen Erfassungsprozess startet, der die folgenden Schritte umfasst:

a) Durchführen - zu gleichmäßig in einem ersten Zeitintervall verteilten Zeitpunkten - einer Folge von n Detektionen des Zustands des Signals $S_1$, wobei n eine ganze Zahl größer als 1 ist, und dabei bei jeder dieser Detektionen eine bestimmte Zählvariable einer Folge von n Zählvariablen $x_0$, ..., $x_{n-1}$ in Abhängigkeit von dem genannten Zustand erhöhen oder unverändert lassen,
b) Wiederholen des Schritts a) in einem oder mehreren weiteren Zeitintervallen, jedes gleich dem genannten ersten Zeitintervall,
c) Anhalten des genannten Erfassungsprozesses zu einem Endzeitpunkt $t_{fin}$,
wobei der genannte Prozess außerdem darin besteht:
d) in der genannten Folge von Zählvariablen $x_0$, ..., $x_{n-1}$ die jeweiligen Werte von benachbarten Zähleinrichtungen paarweise zu vergleichen,
e) die beiden benachbarten Zählvariablen $x_j$ und $x_{j+1}$, den den größten Abstand unter allen Abständen zwischen zwei benachbarten Variablen aufweisen, zu identifizieren, wobei j eine ganze Zahl ist,
f) die Phasenverschiebung zwischen $S_0$ und $S_1$ zu berechnen.

**2.** Verfahren nach Anspruch 1, wobei die Aktion zur Erhöhung der genannten Zählvariablen in Schritt b) einer Inkrementierung der genannten Zählvariablen mit einem Inkrementierungswert entspricht, der fest ist oder variabel in Abhängigkeit von dem genannten detektierten Zustand.

**3.** Verfahren nach Anspruch 1 oder 2, wobei man den Schritt b) eine ganzzahlige Anzahl von Malen mit Perioden der Dauer Ts wiederholt.

**4.** Verfahren nach einem der Ansprüche 1 bis 3, wobei der Erfassungsprozess wiederholt wird bis eine der Zählvariablen einen Wert $x_{Schwelle\_1}$ erreicht, wobei $x_{Schwelle\_1}$ vorher festgelegt wird und/oder im Laufe des genannten Erfassungsprozesses variieren kann.

**5.** Verfahren nach einem der Ansprüche 1 bis 4, wobei der Erfassungsprozess wiederholt wird bis die Zählvariablendifferenz am Ausgang der beiden benachbarten Zähleinrichtungen einen Schwellenwert $X_{Schwelle\_2}$ erreicht, wobei $x_{Schwelle\_2}$ vorher festgelegt wird und/oder im Laufe des genannten Erfassungsprozesses variieren kann.

**6.** Verfahren nach einem der Ansprüche 1 bis 5, wobei das Signal $S_1$ ein digitales Signal ist.

**7.** Verfahren nach Anspruch 6, wobei man das digitale Signal durch Digitalisierung eines analogen Signals erhält.

**8.** Verfahren nach einem der Ansprüche 1 bis 5, wobei das Signal $S_1$ ein analoges Signal ist.

**9.** Verfahren nach einem der Ansprüche 1 bis 5, wobei das Signal $S_1$ ein über mehrere Bits digitalisiertes Signal ist.

**10.** Verfahren nach Anspruch 9, wobei die Zähleinrichtungen die Zählvariable um einen Inkrementiarungswart $Q_2$ inkrementieren, dessen Vorzeichen vom Zustand des detektierten digitalisierten Signals abhängig ist.

**11.** Verfahren nach einem der Ansprüche 1 bis 10, wobei die Phasenverschiebung mittels eines in einem zwischen $(j/n)*2\Pi$ und $((j+1)/n)*2\Pi$ enthaltenen Intervall gewählten Werts ermittelt wird.

**12.** Verfahren zum Auslesen eines Transponders oder eines Etiketts, umfassend:

- das Senden eines Signals mit einer bestimmten Frequenz durch eine Lesevorrichtung,
- das Empfangen - durch die Lesevorrichtung - eines durch den Transponder oder das Etikett gesendeten anderen Signals $S_1$,
- das Durchführen eines Verfahrens nach einem der Ansprüche 1 bis 12.

**13.** Verfahren nach Anspruch 12, wobei durch die Lesevorrichtung ein Signal $S_0$ mit der Periode Ts gesendet wird.

**14.** Vorrichtung zur Bewertung der Phasenverschiebung eines Signals $S_1$ mit einer Periode im Wesentlichen gleich der Periode Ts in Bezug auf ein Referenzsignal $S_0$ der Periode Ts, umfassend:

- Zähleinrichtungen $(100_0, ..., 100_{n-1})$, wobei n eine ganze Zahl größer als 1 ist und jede der Zähleinrichtungen fähig ist, wenn sie betätigt wird einen momentanen Zustand des Signals $S_1$ zu detektieren und eine Zählvariable, der sie unter n Zählvariablen $x_0, ..., x_{n-1}$ zugeordnet ist, in Abhängigkeit von dem detektierten momentanen Zustand zu erhöhen oder unverändert zu lassen,
- Steuereinrichtungen (110), fähig periodisch, sukzessiv und in einer vorher festgelegten Ordnung die n Zähleinrichtungen in einem Zeitintervall, dessen Dauer gleich der Periodendauer Ts des Signals $S_0$ ist, und zu Zeitpunkten zu betätigen, die gleichmäßig über das genannte Zeitintervall verteilt sind,
- Vergleichseinrichtungen (130), fähig unter den n Zählvariablen $x_0, ..., x_{n-1}$ der n Zähleinrichtungen $(100_0, ..., 100_{n-1})$ die Zählvariablenwerte von jeder der benachbarten Zähleinrichtungen paarweise zu vergleichen, wobei der Vergleich durch die genannten Vergleichseinrichtungen durchgeführt wird, was ermöglicht, den größten Abstand zu bestimmen,
- Bewertungseinrichtungen der Phasenverschiebung zwischen $S_0$ und $S_1$ in Abhängigkeit von dem größten bestimmten Abstand.

**15.** Vorrichtung nach Anspruch 14, wobei jede Zähleinrichtung fähig ist, wenn sie betätigt wird, einen momentanen Zustand des Signals $S_1$ zu detektieren und eine Zählvariable, der sie unter n Zählvariablen $x_0, ..., x_{n-1}$ zugeordnet ist, in Abhängigkeit von dem detektierten momentanen Zustand zu erhöhen oder unverändert zu lassen.

**16.** Vorrichtung nach Anspruch 15, außerdem umfassend: Einrichtungen zur Bestimmung des Mittelwerts des Signals $S_1$, wobei jede der Zähleinrichtungen fähig ist, wenn sie betätigt wird, einen momentanen Zustand des Signals $S_1$ zu detektieren und eine Zählvariable, der sie unter n Zählvariablen $x_0, ..., x_{n-1}$ zugeordnet ist, in Abhängigkeit von dem detektierten momentanen Zustand und des Mittelwerts des Signals $S_1$ zu inkrementieren oder unverändert zu lassen.

**17.** Vorrichtung nach einem der Ansprüche 14 bis 16, die außerdem Einrichtungen zur Erzeugung eines Signals $S_0$ der Periode $T_s$ umfasst.

**18.** Vorrichtung nach Anspruch 17, die die Einrichtungen zur Erzeugung eines Signals $S_0$ der Periode $T_s$ mit einem Taktgeber und/oder Frequenzteilereinrichtungen umfasst.

**19.** RFID-Vorrichtung zum Auslesen eines Transponders oder eines Etiketts, umfassend:

- Einrichtungen zum Senden von für ein Etikett oder einen Transponder bestimmten Signalen,
- Einrichtungen zum Empfangen der von einem Etikett oder einem Transponder stammenden Signale,
- eine Vorrichtung nach einem der Ansprüche 14 bis 18.

FIG. 1

FIG. 2

FIG. 3